# EUROPEAN PATENT APPLICATION

(11) **EP 4 657 438 A1**
(43) Date of publication of application: **03.12.2025**
(21) Application number: 25177562.3
(22) Date of filing: 20.05.2025
(51) Int. Cl.: G11C 13/00

(54) **ERASE ALGORITHM FOR NON-VOLATILE MEMORY DEFINING A WEAK PROGRAM STATE AS AN ERASE STATE**

(30) Priority: 30.05.2024 US 202418678273
(71) Applicant: Crossbar, Inc., Santa Clara CA 95054 (US)
(72) Inventor: Li, Zhi, Santa Clara, 95054 (US); Shieh, Ming-Huei, Cupertino, 95014 (US); Lau, Derek, Santa Clara, 95054 (US)
(74) Representative: Samson & Partner Patentanwälte mbB

(57) **Abstract**

Improved erase techniques enhance longevity of two-terminal non-volatile memory and can mitigate or avoid erase state memory failures. An erase process can include performing an erase operation(s) on a two-terminal memory cell, followed by a weak program operation. An erase-verify process can determine whether the memory cell has a read current within a target range. In one or more embodiments, additional erase and weak program cycles can be implemented to initiate a weakly programmed state that can be defined as an erase state. The weakly programmed state can be configured so that drift or diffusion over time results in higher resistance not reversion to a low resistance state, to mitigate or avoid erase failure of the two-terminal memory cell.

## Description

### INCORPORATION BY REFERENCE

U.S. Patent Application No. 16/291,467 filed March 4, 2019, and titled RESISTIVE RANDOM ACCESS MEMORY PROGRAM AND ERASE TECHNIQUES AND APPARATUS, and U.S. Patent Application No. 18/119,104 filed March 8, 2023, and titled ERASE ALGORITHM WITH A WEAK PROGRAM PULSE FOR NON-VOLATILE MEMORY are hereby incorporated by reference herein in their respective entireties and for all purposes.

### TECHNICAL FIELD

The subject disclosure relates generally to operations for controlling non-volatile memory, and as one illustrative example, an enhanced erase algorithm for a non-volatile memory.

### BACKGROUND

Resistive-switching memory represents a recent innovation within the field of integrated circuit technology. While much of resistive-switching memory technology is in the development stage, various technological concepts for resistive-switching memory have been demonstrated and are in one or more stages of verification to prove or disprove associated theories or techniques. The inventors believe that resistive-switching memory technology shows compelling evidence to hold substantial advantages over competing technologies in the semiconductor electronics industry.

Resistive-switching memory cells can be configured to have multiple states with measurably distinct resistance values. For instance, for a single bit cell, the restive-switching memory cell can be configured to exist in a relatively low resistance state or, alternatively, in a relatively high resistance state. Multi-bit cells might have additional states with respective resistances that are distinct from one another and distinct from the relatively low resistance state and the relatively high resistance state. The distinct resistance states of the resistive-switching memory cell can be correlated with logical information states, facilitating digital memory operations. Accordingly, arrays of many such memory cells can provide many bits of digital memory storage.

Resistive-switching memory can be induced to enter one or another resistive state in response to an external condition. Thus, in transistor parlance, applying or removing the external condition can serve to program or de-program (e.g., erase) the memory. Moreover, depending on physical makeup and electrical arrangement, a resistive-switching memory cell can generally maintain a programmed or de-programmed state. Maintaining a state might require other conditions be met (*e.g*., existence of a minimum operating voltage, existence of a minimum operating temperature, and so forth), or no conditions be met, depending on the characteristics of a memory cell device.

The inventors have put forth several proposals for practical utilization of resistive-switching technology to memory applications for electronic devices. For instance, resistive-switching elements are often theorized as viable alternatives, at least in part, to metal-oxide semiconductor (MOS) type memory transistors employed for electronic storage of digital information. Models of resistive-switching memory devices provide some potential technical advantages over non-volatile FLASH MOS type transistors.

In light of the above, continued development of practical utilizations of resistive-switching technology are pursued by the Assignee of the present disclosure.

### SUMMARY

The following presents a simplified summary of the specification in order to provide a basic understanding of some aspects of the specification. This summary is not an extensive overview of the specification. It is intended to neither identify key or critical elements of the specification nor delineate the scope of any particular embodiments of the specification, or any scope of the claims. Its purpose is to present some concepts of the specification in a simplified form as a prelude to the more detailed description that is presented in this disclosure.

The present disclosure provides for improved erase techniques and apparatuses for improving performance and longevity of non-volatile memory. The various techniques include performing an erase operation(s) on a two-terminal memory cell, followed by a weak program operation. An erase-verify process can determine whether the memory cell has a read current within a target range. In one or more embodiments, additional erase and weak program cycles can be implemented to initiate a weakly programmed state that can be defined as an erase state. The weakly programmed state can be configured to drift to a higher resistance, to mitigate or avoid erase failure in which the memory cell returns to a low resistance state.

In one or more embodiments, the present disclosure provides a method for erasing a two-terminal memory cell. The two-terminal memory cell can comprise selecting a two-terminal non-volatile memory cell in a set memory cell state, and performing an erase process on the two-terminal non-volatile memory cell. In further embodiments, the method can comprise performing a weak program process on the two-terminal non-volatile memory cell, and can comprise repeating the erase process and the weak program process an integer: N times, wherein N is larger than one. Still further, the method can comprise following an N^{th} erase process and N^{th} weak program process, terminate the method.

In additional embodiments, the present disclosure provides a method for erasing a two-terminal memory cell. The method can comprise selecting a two-terminal memory cell in a set state for a reset operation, and performing an erase pulse on the selected two-terminal memory cell. In addition, the method can comprise performing a weak program process on the selected two-terminal memory cell. Moreover, the method can comprise reading a current value of the selected two-terminal memory cell, and can comprise determining whether the current value is greater than a first current threshold associated with a reset state and lower than a second current threshold associated with the set state. In addition to the foregoing, the method can comprise terminating the reset operation in response to determining a read current value of the selected two-terminal memory cell is greater than the first current threshold and lower than the second current threshold.

The following description and the drawings set forth certain illustrative aspects of the specification. These aspects are indicative, however, of but a few of the various ways in which the principles of the specification may be employed. Other advantages and novel features of the specification will become apparent from the following detailed description of the specification when considered in conjunction with the drawings.

### BRIEF DESCRIPTION OF THE DRAWINGS

Various aspects or features of this disclosure are described with reference to the drawings, wherein like reference numerals are used to refer to like elements throughout. In this specification, numerous specific details are set forth in order to provide a thorough understanding of this disclosure. It should be understood, however, that certain aspects of the subject disclosure may be practiced without these specific details, or with other methods, components, materials, *etc.* In other instances, well-known structures and devices are shown in block diagram form to facilitate describing the subject disclosure.
Figure 1 depicts a schematic diagram of an example two-terminal resistive switching memory array and operation circuitry according to disclosed embodiments;
Figure 2 illustrates an example one transistor one resistor (1T1R) resistive switching memory circuit according to further embodiments disclosed herein;
Figure 3 illustrates an example diagram of a two-terminal memory cell with a robust filament having good set state retention according to various embodiments;
Figure 4 depicts an example diagram of a two-terminal memory cell having a partially reset filament and a weakly set filament in embodiments of the disclosure;
Figure 5 illustrates an example erase and weak program cycle for forming a weakly set program state for a two-terminal memory cell in additional embodiments;
Figure 6 depicts a graph of example cell current values for a set state, weakly set state, erase state and partial erase state according to still further embodiments;
Figure 7 illustrates a flowchart of a sample method for erasing a two-terminal memory cell according to one or more embodiments;
Figure 8 depicts a flowchart of an example method for erasing a two-terminal memory cell according to additional embodiments;
Figure 9 illustrates a block diagram of an example electronic operating environment for implementing aspects of the present disclosure in disclosed embodiments;
Figure 10 depicts a block diagram of a sample computing environment for implementing various aspects of the present disclosure.

### DETAILED DESCRIPTION

### INTRODUCTION

Aspects of the present disclosure provide for an improved erase process for two-terminal non-volatile memory. For instance, in one or more embodiments, an improved erase process can utilize one or more weak program pulses in conjunction with erasing a two-terminal, non-volatile resistive switching memory device. In some embodiments, the improved erase process can cycle between one or more erase pulse(s) and a weak program pulse. A fixed or variable number of cycles of the erase pulse(s) and weak program pulse can be implemented in various embodiments. Moreover, the improved erase process can terminate with a weak program pulse, and a resulting weakly programmed state (also referred to herein as a weakly set state) can be defined as an erased or a reset state for a two-terminal memory cell. The weakly set state can mitigate or avoid an erase failure, in which an erased two-terminal memory cell inadvertently reverts to a set state over time. The weakly set state tends to drift to a fully erased (or fully reset) state over time instead of the set state.

As utilized herein, the term "substantially" and other relative terms or terms of degree (*e.g.,* about, approximately, substantially, and so forth) are intended to have the meaning specified explicitly in conjunction with their use herein, or a meaning which can be reasonably inferred by one of ordinary skill in the art, or a reasonable variation of a specified quality(ies) or quantity(ies) that would be understood by one of ordinary skill in the art by reference to this entire specification (including the knowledge of one of ordinary skill in the art as well as material incorporated by reference herein). As an example, a term of degree could refer to reasonable manufacturing tolerances about which a specified quality or quantity could be realized with fabrication equipment. Thus, as a specific illustration, though non-limiting, for an element of an integrated circuit device expressly identified as having a dimension of about 50 angstroms (Å), the relative term "about" can mean reasonable variances about 50 Å that one of ordinary skill in the art would anticipate the specified dimension of the element could be realized with commercial fabrication equipment, industrial fabrication equipment, laboratory fabrication equipment, or the like, and is not limited to a mathematically precise quantity (or quality). In other examples, a term of degree could mean a variance of +/- 0-3%, +/- 0-5%, or +/- 0-10% of an expressly stated value, where suitable to one of ordinary skill in the art to achieve a stated function or feature of an element disclosed herein. In still other examples, a term of degree could mean any suitable variance in quality(ies) or quantity(ies) that would be suitable to accomplish an explicitly disclosed function(s) or feature(s) of a disclosed element. Accordingly, the subject specification is by no means limited only to specific qualities and quantities disclosed herein, but includes all variations of a specified quality(ies) or quantity(ies) reasonably conveyed to one of ordinary skill in the art by way of the context disclosed herein.

As the name implies, a two-terminal memory device has two terminals or electrodes. Herein, the terms "electrode" and "terminal" are used interchangeably. Generally, a first electrode of a two-terminal resistive switching device is referred to as a "top electrode" (TE) and a second electrode of the two-terminal resistive switching device is referred to as a "bottom electrode" (BE), although it is understood that electrodes of two-terminal resistive switching devices can be according to any suitable arrangement, including a horizontal arrangement in which components of a memory cell are (substantially) side-by-side rather than overlying one another. Situated between the TE and BE of a two-terminal memory device is typically an interface layer sometimes referred to as a switching layer, a resistive switching medium (RSM) or a resistive switching layer (RSL). When incorporating a RSM, the two-terminal memory device can be referred to as a (two-terminal) resistive switching device.

Composition of memory cells, generally speaking, can vary per device with different components, materials or deposition processes selected to achieve desired characteristics (*e.g*., stoichiometry/non-stoichiometry, volatility/non-volatility, on/off current ratio, switching time, read time, memory durability, program/erase cycle, and so on). One example of a conductive bridge random access memory (RAM) or programmable metallization cell device can comprise: a relatively (electrochemically) inert conductive layer, *e.g.,* metal, metal-alloy, metal-nitride, etc. (*e.g*., comprising W, Ni, Pt, TiₓN_{y} (where x and y are respective suitable positive numbers), Ir, or other suitable metal compounds) and an electrochemically active conductive layer, *e.g.,* metal, metal-alloy, metal-nitride, *etc.* (*e.g.,* comprising AlₓN_{y} (*e.g.,* non-stoichiometric and conducting), Ag, Cu, or other suitable metal compounds), separated by a resistive switching layer (RSL) (*e.g*., comprising AlₓO_{y}, SiₓO_{y}, TiₓO_{y}, or other suitable oxide). Under suitable conditions, the active metal-containing layer can provide filament-forming ions (*e.g.,* Al, Ag, Cu, etc.) to the RSL. In such embodiments, a conductive filament (*e.g.,* formed by the ions) can facilitate electrical conductivity through at least a subset of the RSL, and a resistance of the filament-based device can be determined, as one example, by a tunneling resistance between the filament and the conductive layer. A memory cell having such characteristics may be described as a programmable metallization cell, conductive bridge RAM, or a filamentary-based device.

A RSL (which can also be referred to in the art as a resistive switching media (RSM)) can comprise, *e.g*., an undoped amorphous Si-containing layer, a semiconductor layer having intrinsic characteristics, a stoichiometric or non-stoichiometric silicon nitride (*e.g.,* SiN, Si₃N₄, SiNₓ, etc.), a Si sub-oxide (*e.g*., SiOₓ wherein x has a value between 0.1 and 2), a Si sub-nitride, a metal oxide, a metal nitride, a non-stoichiometric silicon compound, and so forth. Other examples of materials suitable for the RSL could include SiₓGe_{y}O_{z} (where x, y and z are respective suitable positive numbers), a silicon oxide (*e.g.,* SiO_{N}, where N is a suitable positive number), a silicon oxynitride, an undoped amorphous Si (a-Si), amorphous SiGe (a-SiGe), TaO_{B} (where B is a suitable positive number), HfO_{C} (where C is a suitable positive number), TiO_{D} (where D is a suitable number), Al₂O_{E} (where E is a suitable positive number) and so forth, a nitride (*e.g.,* AlN, SiN), or a suitable combination thereof.

In some embodiments, a RSL employed as part of a non-volatile memory device (non-volatile RSL) can include a relatively large number (*e.g*., compared to a volatile selector device) of material voids or defects to trap neutral metal particles (*e.g*., at low voltage) within the RSL. The large number of voids or defects can facilitate formation of a thick, stable structure of the neutral metal particles. In such a structure, these trapped particles can maintain the non-volatile memory device in a low resistance state in the absence of an external stimulus (*e.g*., electrical power), thereby achieving non-volatile operation.

An active metal-containing layer for a filamentary-based memory cell can include, among others: silver (Ag), gold (Au), titanium (Ti), titanium-nitride (TiN) or other suitable compounds of titanium, nickel (Ni), copper (Cu), aluminum (Al), chromium (Cr), tantalum(Ta), iron (Fe), manganese (Mn), tungsten (W), vanadium (V), cobalt (Co), platinum (Pt), hafnium (Hf), and palladium (Pd). Other suitable conductive materials, as well as stoichiometric or non-stoichiometric: compounds, nitrides, oxides, alloys, mixtures or combinations of the foregoing or similar materials can be employed for the active metal-containing layer in some aspects of the subject disclosure. Further, a non-stoichiometric compound, such as a non-stoichiometric metal oxide/metal-oxygen or metal nitride/metal nitrogen (*e.g.,* AlOₓ, AlNₓ, CuOₓ, CuNₓ, AgOₓ, AgNₓ, and so forth, where x is a suitable positive number or range of numbers, such as: 0<x<2, 0<x<3, 0<x<4 or other number/range of numbers depending on metal compound, which can have differing values for differing ones of the non-stoichiometric compounds) or other suitable metal compound can be employed for the active metal-containing layer, in at least one embodiment.

In one or more embodiments, a disclosed filamentary resistive switching device can include an active metal layer comprising a metal-nitrogen selected from the group consisting of: TiNₓ, TaNₓ, AlNₓ, CuNₓ, WNₓ and AgNₓ, where x is a positive number (or range of numbers) that can vary per metal-nitrogen material. In a further embodiment(s), the active metal layer can comprise a metal-oxygen selected from the group consisting of: TiOₓ, TaOₓ, AlOₓ, CuOₓ, WOₓ and AgOₓ where x is a positive number (or range of numbers) that can likewise vary per metal-oxygen material. In yet another embodiment(s), the active metal layer can comprise a metal oxygen-nitrogen selected from the group consisting of: TiOₐN_{b}, AlOₐN_{b}, CuOₐN_{b}, WOₐN_{b} and AgOₐN_{b}, where a and b are suitable positive numbers/ranges of numbers. The disclosed filamentary resistive switching device can further comprise a switching layer comprising a switching material selected from the group consisting of: SiO_{y}, AlN_{y}, TiO_{y}, TaO_{y}, AlO_{y}, CuO_{y}, TiNₓ, TiN_{y}, TaNₓ, TaN_{y}, SiOₓ, SiN_{y}, AlNₓ, CuNₓ, CuN_{y}, AgNₓ, AgN_{y}, TiOₓ, TaOₓ, AlOₓ, CuOₓ, AgOₓ, and AgO_{y}, where x and y are positive numbers (or ranges), and y is larger than x. Various combinations of the above are envisioned and contemplated within the scope of embodiments of the present invention.

In one example, a disclosed filamentary resistive switching device comprises a particle donor layer (e.g., the active metal-containing layer) comprising a stoichiometric or non-stoichiometric metal compound (or mixture) and a resistive switching layer. In one alternative embodiment of this example, the particle donor layer comprises a metal-nitrogen: MNₓ, *e.g.,* AgNₓ, TiNₓ, AlNₓ, *etc.,* and the resistive switching layer comprises a metal-nitrogen: MN_{y}, *e.g.,* AgO_{y}, TiO_{y}, AlO_{y}, and so forth, where y and x are positive numbers (or ranges), and in some cases y is larger than x. In an alternative embodiment of this example, the particle donor layer comprises a metal-oxygen: MOₓ, *e.g.,* AgOₓ, TiOₓ, AlOₓ, and so on, and the resistive switching layer comprises a metal-oxygen: MO_{y}, *e.g.,* AgO_{y}, TiO_{y}, AlO_{y}, or the like, where y and x are positive numbers (or ranges), and in some cases y is larger than x. In yet another alternative, the metal compound of the particle donor layer is a MNₓ (*e.g.,* AgNₓ, TiNₓ, AlNₓ, *etc.*), and the resistive switching layer is selected from a group consisting of MO_{y} (*e.g.,* AgO_{y}, TiO_{y}, AlO_{y}, etc.) and SiO_{y}, where x and y are typically non-stoichiometric values, or vice versa in a still further embodiment.

As utilized herein, variables x, y, a, b, and so forth representative of values or ratios of one element with respect to another (or others) in a compound or mixture can have different values (or ranges) suitable for respective compounds/mixtures, and are not intended to denote a same or similar value or ratio among the compounds. Mixtures can refer to non-stoichiometric materials with free elements therein - such as metal-rich nitride or oxide (metal-oxide/nitride with free metal atoms), metal-poor nitride or oxide (metal-oxide/nitride with free oxygen/nitrogen atoms) - as well as other combinations of elements that do not form traditional stoichiometric compounds as understood in the art. Some details pertaining to embodiments of the subject disclosure can be found in the following U.S. patent applications that are licensed to the assignee of the present application for patent: Application Serial Number 11/875,541 filed October 19, 2007 and Application Serial Number 12/575,921 filed October 8, 2009; each of the foregoing patent applications are hereby incorporated by reference herein in their respective entireties and for all purposes in addition to those incorporated by reference elsewhere herein.

Some embodiments of the subject disclosure can employ a switching device that, in a first mode of operation (e.g., referred to herein as standard formation, multiple time programmable (MTP) operation, etc.), operates as a bipolar switching device that exhibits a first switching response (*e.g*., programming to one of a set of program states) to an electrical signal of a first polarity and a second switching response (*e.g*., erasing to an erase state) to the electrical signal having a second polarity. The bipolar switching device is contrasted, for instance, with a unipolar device that exhibits both the first switching response (*e.g*., programming) and the second switching response (*e.g*., erasing) in response to electrical signals having the same polarity and different magnitudes.

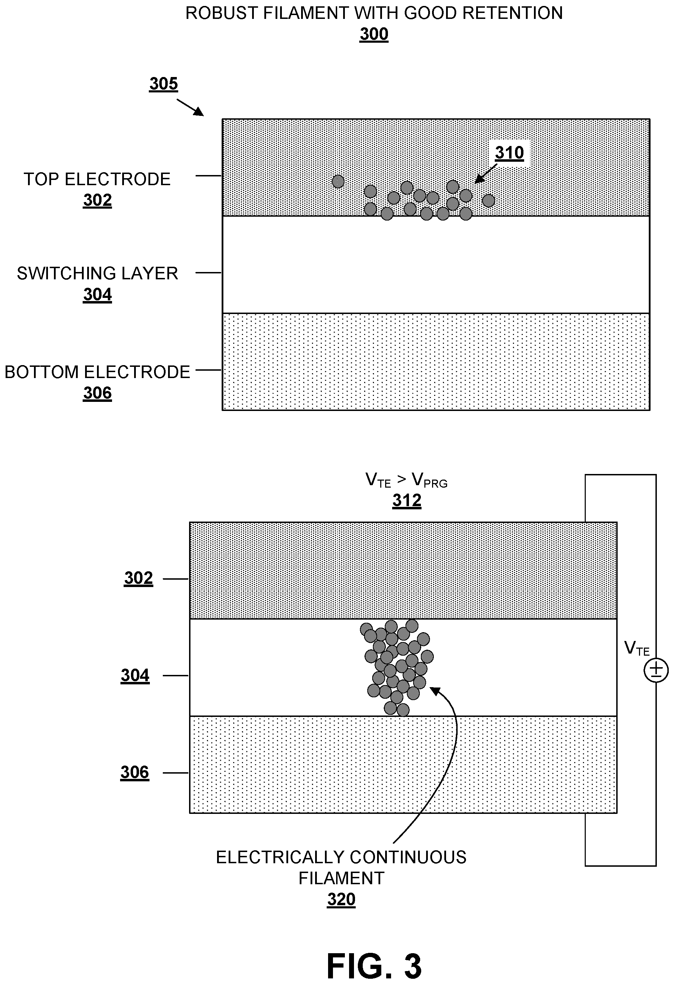

One resistive switching modality for a bipolar device involves a reversibly formable conductive filament. The reversibly formable conductive filament - also referred to as a filamentary-based switching device - can operate differently in response to different polarity external stimuli. As an example, a conductive path or a filament forms through a non-volatile RSL in response to a suitable program voltage applied across the memory cell. In particular, upon application of a programming voltage, metallic ions are generated from the active metal-containing layer and migrate into the non-volatile RSL layer. The metallic ions can occupy voids or defect sites within the non-volatile RSL layer. In some embodiments, upon removal of the bias voltage, the metallic ions become neutral metal particles and remain trapped in voids or defects of the non-volatile RSL layer. When sufficient particles become trapped, a filament is formed and the memory cell switches from a relatively high resistive state, to a relatively low resistive state (*e.g.,* see Figure 3, *infra*)*.*

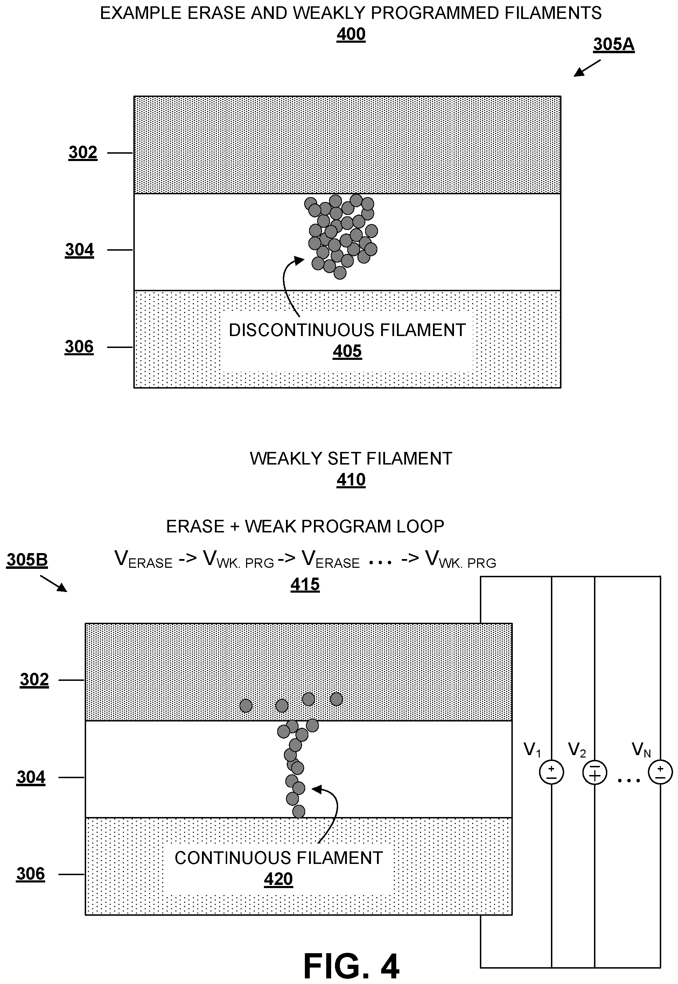

Once a conductive filament is formed, trapped conductive particles embodying the conductive path or filament through the non-volatile RSL layer, and the resistance is typically determined by a tunneling resistance between one or more such particles and an electrical conductive material adjacent to the non-volatile RSL layer. In some resistive-switching devices, an erase process can be implemented to deform the conductive filament, at least in part, causing the memory cell to return to the high resistive state from the low resistive state. More specifically, upon application of an erase bias voltage, the metallic particles trapped in voids or defects of the non-volatile RSL become mobile ions and migrate back towards the active metal layer, or disassociate within the RSL (or a combination of the foregoing) to break electrical conductivity of the conductive filament through the RSL layer (*e.g.,* see Figure 4, *infra*)*.* This change of state, in the context of memory, can be associated with respective states of a binary bit.

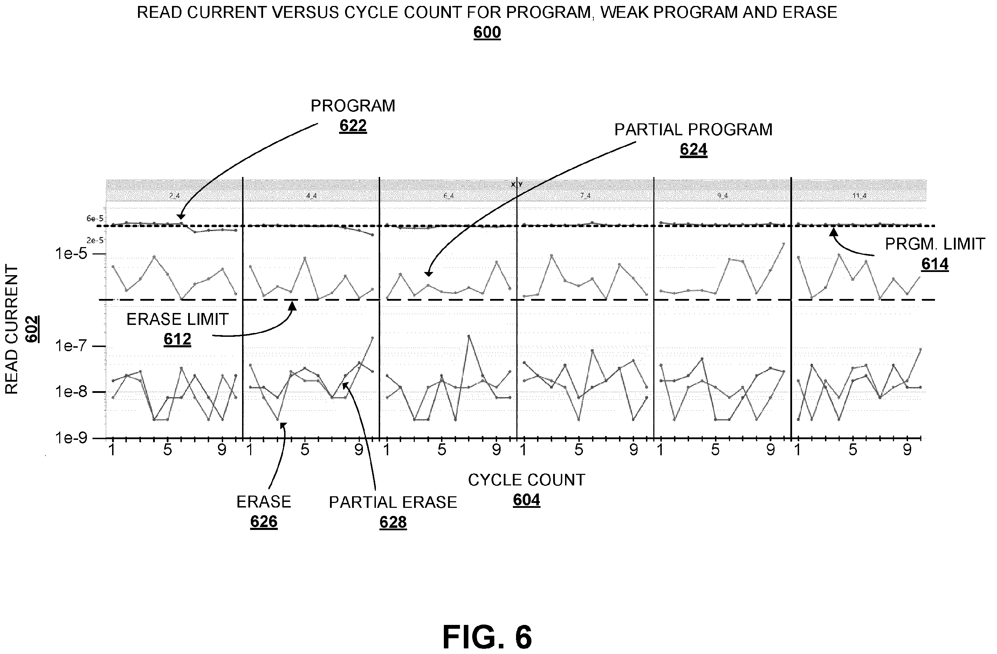

In some disclosed embodiments, completion of a conductive filament (e.g., standard formation) can involve only a few particles (*e.g*., atoms, ions, conductive compounds, *etc.*) of conductive material, or less. As one particular example, an electrically continuous conductive filament could be established by position of 1-3 atoms at a boundary of a switching layer, whereas repositioning of one or more of these atoms can break that electrical continuity, in some embodiments (*e.g*., compare electrically continuous filament 320 of Figure 3 to discontinuous filament 405 of Figure 4, *infra).* Because the scale can be so small between a completed filament and non-completed filament, an erased cell can become disturbed over time, reverting to a programmed or conductive state if atoms removed from the boundary drift into suitable position to reform electrical continuity of the conductive filament. This reversion from an erase state to a program state is called an erase disturb, or more generally a bit failure. Various embodiments of the present disclosure provide an improved erase process to form a weakly set filament of only a few ions in width (*e.g*., see continuous filament 420 of Figure 4, *infra*) having a relatively low cell conductivity (*e.g.,* see partial program 624 of Figure 6 relative to program 622, *infra*)*.* The phenomenon of atomic drift as applied to the very thin, weakly set state tends to form a discontinuous filament, not a set filament. Accordingly, disclosed erase processes forming a weakly set filament and defining the weakly set filament as a reset state can significantly reduce erase disturb bits and mitigate or avoid data loss in non-volatile resistive switching memory devices.

### OVERVIEW

For memory devices having switching characteristics based upon the presence or absence of a conductive filament(s) therein to change the resistance of the memory device between a low resistance state (filament present) and a high resistance state (filament disrupted), retention problems (short-term memory erase failures) can occur in some memory devices. Such failures include an erase disturb condition, which involves erasing a memory typically with a negative voltage, and after an amount of time, having the memory by itself return to a programmed state (*e.g.,* from a high resistance state to a low resistance state).

Although a filament of a programmed memory cell may be immediately disrupted during an erase cycle, the physical movement of the conductive particles of the filament can be impermanent. More specifically, the disrupted conductive particles may relax and reform the conductive filament, an amount of time after the erase cycle. The amount of time may be short (corresponding to short-term memory problems) for some memory devices and long (corresponding to long-term memory endurance problems) for other memory devices on the same memory structure.

Embodiments disclosed herein present a modified erase process wherein after an initial erase cycle on a two-terminal memory device (typically with one or more negative - or first polarity - voltage pulses), a weak programming cycle is applied (typically with a positive voltage or a second polarity voltage). It is believed that the weak programming cycle causes or facilitates memory devices that have short-term or long-term memory erase tendencies to program (*e.g.,* to re-enter the low resistance state). In some embodiments, after applying the erase voltage (typically negative) and erase current, instead of returning to zero bias immediately, the weak program voltage (typically positive) may be applied, followed by returning to zero bias. In other words, the weak programming pulse may be considered part of the erase process in some embodiments, or can be a separate operation from an erase process in other embodiments.

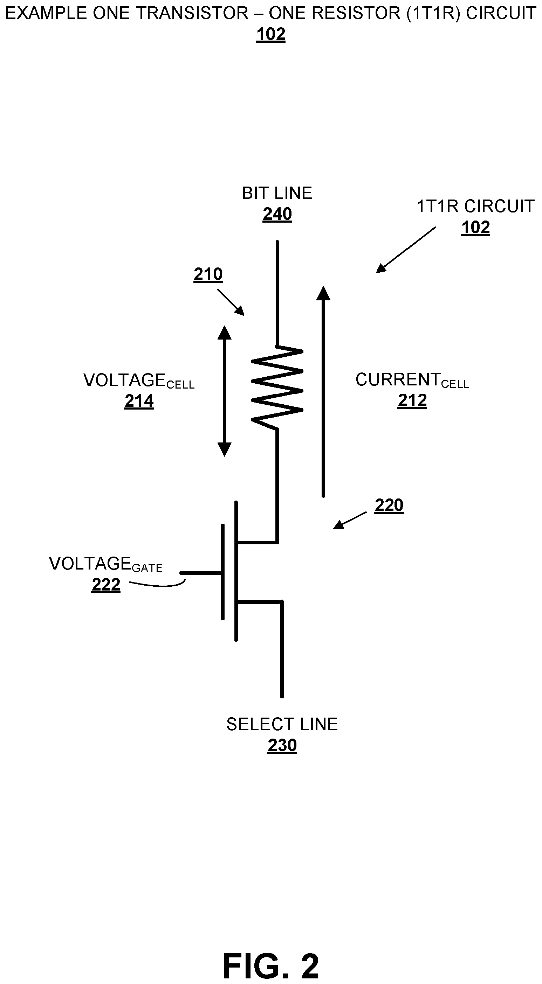

In various embodiments, the weak program signal may have a smaller magnitude than a normal program signal (*e.g.,* 20% to 75% smaller than the normal program signal). The smaller magnitude can be a smaller voltage, a smaller current, a smaller pulse duration, or the like, or a suitable combination of the foregoing. In some embodiments, the weak program signal can be about the same or greater in magnitude than a regular program, but the duration may be significantly shorter, or fewer program pulses can be implemented. In other embodiments, a program voltage or duration can be the same as the normal program signal, and the weak program signal can be characterized by a lower magnitude electrical current (*e.g.,* see Figure 2, *infra*)*.* In still further embodiments, the weak program signal can combine a combination of the foregoing (*e.g.,* a combination of: fewer program pulses, shorter program duration, lower program voltage, lower program current, and so forth).

In at least one embodiment, a disclosed erase process can include a cycle of one or more erase pulses followed by one or more weak program pulses. Each pulse can be followed by a read-verify operation compared a cell current to a target value. For an erase portion of the cycle, the read-verify can utilize a first target value, and for the weak program portion of the cycle the read-verify can utilize a second target value or a target range. The erase portion can repeat the erase pulse until the read-verify determines a cell current below the first target value. The weak program portion can repeat a weak program pulse until the cell current exceeds the second target value, or the cell current falls within the target range. The cycle can be repeated N times, where N is a positive integer (*e.g.,* 1 or greater).

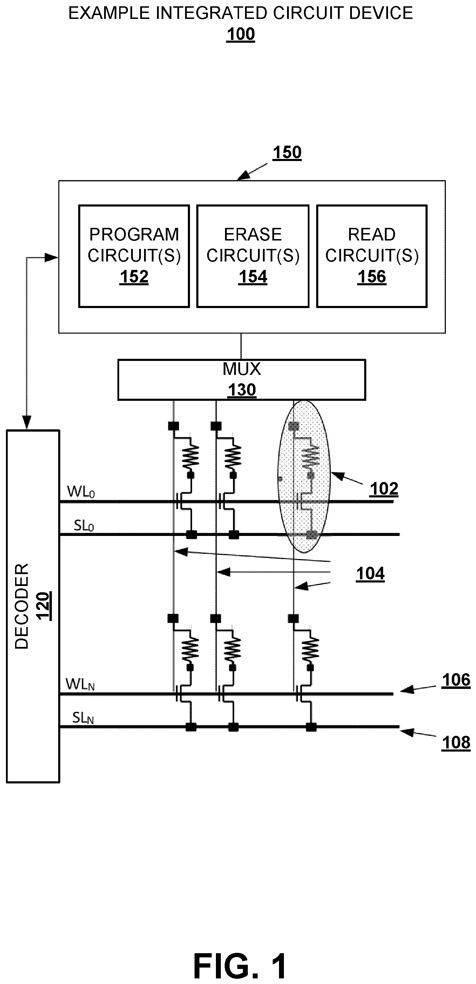

Figure 1 illustrates a block diagram of an example integrated circuit device 100 for an electronic device according to one or more embodiments of the present disclosure. Integrated circuit device 100 can comprise an array of two-terminal memory cells 102, connected at respective first ends thereof to one of a set of bitlines 104, and connected at respective second ends thereof to one of a set of sourcelines 108. For memory cells in a one transistor - one resistive cell configuration (1T1R), access to rows of memory cells can be facilitated by respective wordlines 106.

Operation circuitry 150 accesses respective bitlines 104 utilizing a multiplexer 130, and respective sourcelines 108 (and wordlines 106) via a decoder 120. To facilitate the memory operations disclosed herein, operation circuitry 150 can comprise a program circuit(s) 152, an erase circuit(s) 154 and a read circuit(s) 156.

Program circuit(s) 152 can be configured to apply a program signal(s) having default characteristics, including voltage, current, pulse duration or number of pulses (in a program process), or a suitable combination of the foregoing. Example default voltage for the program process can be in a range from 2.5 volts (v) to 3.5v (*e.g.,* 2.6v, 2.8v, 3.0v, 3.2v, 3.4v, *etc.*)*,* example default current can be in a range from about 300µA to about 400µA, example default pulse duration can be 1 microsecond (µs) to 100µs (*e.g.,* 1µs, 5µs, 10µs, 25µs, 30µs, ...), and an example default number of pulses can be multiple pulses, ten pulses, 20 pulses, 50 pulses, 100 pulses, 500 pulses, or any suitable value(s) or range(s) between any of the foregoing.

Further, program circuit(s) 152 can be configured to apply a weak program process having at least one different characteristic from the default characteristics. The different characteristic(s) can comprise a different voltage, current, pulse duration or number of pulses, or a combination of the foregoing, however the weak program process will have the same polarity as the program process. It should be appreciated that in general the weak program process will have a reduced voltage magnitude, reduced current, reduced pulse duration or reduced number of pulses, but in at least some embodiments the weak program process can have at least one of these characteristics increased, with one or more others reduced. As one example, the weak program process can have a voltage from about 1.6v to about 2.6v (*e.g.,* 1.8v, 2.0v, 2.2v, 2.3v, 2.5v, and so forth), a pulse duration from 1µs to 100µs (*e.g.,* about 5µs, about 10µs, about 15µs, about 20µs, and so forth), fewer than five pulses (*e.g.,* two pulses, one pulse, *etc.*), current between about 1/3 and about ¼ the program current (*e.g*., about 60µA to about 120µA).

Erase circuit(s) 154 can be configured to apply an erase process having default characteristics, including voltage, current, pulse duration or number of pulses (in the erase process), or a suitable combination of the foregoing. For bipolar two-terminal memory cells 102, the erase process will generally have voltage of opposite polarity from the program process, but can have different magnitudes from the above characteristics as well. In various embodiments, erase circuit(s) 154 can generate an erase process with a voltage in a range of about -2.0v to - 3.0v, a maximum current from 150µA to 250µA, a pulse duration in a range from about 1µs to about 100µs, and fewer than five pulses (*e.g.,* three pulses, four pulses, one pulse, and so forth).

Read circuit(s) 156 can provide a read pulse configured to maintain -or otherwise avoid disturbing - a resistance state of two-terminal memory cell 102, while determining a value of the resistance state. The read pulse is typically smaller in magnitude than a program or erase pulse (*e.g.,* 2.0v or less; 1.5v or less, and the like). In various embodiments, read pulses can be implemented by read circuit(s) 156 following a program pulse (or weak program pulse) implemented by program circuit(s) 152, or following an erase pulse implemented by erase circuit(s) 154.

Figure 2 illustrates a schematic diagram of an example one transistor - one resistor (1T1R) non-volatile memory circuit 102 (referred to hereinafter as 1T1R circuit 102) according to one or more aspects of the present disclosure. 1T1R circuit 102 includes an electrical series connection of a two-terminal switching device 210 and a transistor 220. A first terminal of two-terminal switching device 210 can be connected to a bit line 240 and a second terminal of two-terminal switching device 210 can be connected to a channel node (*e.g.,* source or drain) of transistor 220. A second channel node (*e.g.,* drain, source) of transistor 220 can be connected to a select line 230.

Application of a (positive) program voltage at bit line 240 and low or ground voltage at select line 230 results in a cell voltage: voltage_{cell} 214 and an electric field across two-terminal switching device 210. The electric field can drive ions from an active electrode of two-terminal switching device 210 through a resistive switching medium thereof to form an electrically continuous conductive filament within two-terminal switching device 210 (*e.g.,* see Figure 3, *infra*)*.* This changes two-terminal switching device 210 from a high resistance state to a low resistance state, as described herein. A quantity of the ions that form the filament can be controlled at least in part by a current magnitude through two-terminal switching device 210: current_{cell} 212. In general, the greater the magnitude of current_{cell} 212 the larger the number of ions driven from the active terminal into the switching medium of two-terminal switching device 210, and the thicker and more stable the resulting conductive filament will be (*e.g.,* see Figure 3). In contrast, a low magnitude of current_{cell} 212 drives fewer ions into the switching material and forms a thinner, less stable conductive filament (*e.g.,* see Figure 4).

In the 1T1R circuit 102 of Figure 2, a voltage at a gate node: voltage_{gate} 222 of transistor 220 can control the magnitude of current_{cell} 212. A higher voltage_{gate} 222 corresponds to higher current_{cell} 212, and a lower voltage_{gate} 222 corresponds with a lower current_{cell} 212. A magnitude of current_{cell} 212 suitable to achieve a thick, stable program filament compared with a thin, weakly programmed filament can vary for different two-terminal switching device 210, depending on size of the switching device, materials of the top electrode and switching medium, and the like. According to various embodiments of the present disclosure, a suitable resistive switching medium can be comprised of AlO, AlN, TiO, HfO, TaO, a-Si, SiO or SiN, or a suitable combination of the foregoing. An active electrode (wherever located: top, bottom, side, diagonal, *etc.*) can be comprised of nitrogen-doped Al, Cu, TiN, Ni, W, Ag, Ta or a suitable combination thereof. A second electrode (non-active) can be comprised of W, TiN, Pt, TaN or the like, or a suitable combination of the foregoing.

In some disclosed embodiments, current_{cell} 212 can be in a first range from about 300µA to about 400µA in conjunction with a program operation or a program pulse, and can correspond to a voltage_{gate} 222 of between about 1.5 volts and about 2.8 volts. In some embodiments, the program operation can comprise a series of program pulses with a cell voltage at bitline 240 in a range from about 2.5 volts to about 3.5 volts, and a voltage_{gate} 222 that is incremented per program pulse starting at about 1.5 volts and ending at about 2.8 volts. The increment per pulse can be about 0.1 volts per pulse, about 0.2 volts per pulse, about 0.3 volts per pulse, or other suitable value.

In further disclosed embodiments, current_{cell} 212 can be in a second range from about 60µA to about 120µA (*e.g.,* 70µA, 80µA, 90µA, 100µA, 110µA, ...) in conjunction with a weak program operation (or weak program pulse), which can correspond to a voltage_{gate} 222 of between about 0 volts to about 1 volt. In some embodiments, the weak program operation can comprise a series of weak program pulses with a cell voltage at bitline 240 in a range from about 2.5 volts to about 3.5 volts, and a voltage_{gate} 222 that is incremented per weak program pulse starting at about 0 volts (*e.g.,* with a first weak program pulse) and end at about 1 volt (*e.g.,* for a subsequent weak program pulse). The increment per weak program pulse can be about 0.1 volts per pulse, about 0.2 volts per pulse, about 0.3 volts per pulse, or other suitable value. In addition to the foregoing, a weak program operation can be implemented in conjunction with current compliance that caps a magnitude of current_{cell} 212 at a fixed current magnitude. The fixed current compliance magnitude can be between about 80µA and about 120µA in various embodiments (*e.g.,* 100µA, *etc.*)*.*

Figure 3 illustrates an example robust filament 300 as part of a two-terminal resistive switching device 305, having good retention and longevity according to various embodiments of the present disclosure. Two-terminal switching device 305 comprises a top (active) electrode 302 serving as source of mobile ions 310, a resistive switching layer 304 and a bottom electrode 306. A voltage exceeding a program voltage V_{PRG} 312 applied at top electrode 302 causes mobile ions 310 to drift through switching layer 304 forming an electrically continuous filament 320 through switching layer 304. This effectively places two-terminal resistive switching device 305 in a low resistance state, and electrically continuous filament 320 readily conducts current between top electrode 302 and bottom electrode 306. A magnitude of the electrical current between top electrode 302 and bottom electrode 306 can vary per device, but as an example can be about 30µA to about 50µA (*e.g.,* 30, 31, ..., 39, 40, 41, ... 49, 50 µA, or other suitable value or range there between).

Figure 4 illustrates example partially erased and weakly set filaments 400 according to one or more additional embodiments of the present disclosure. Two-terminal resistive switching device 305A is shown at the top of Figure 4 in an erased state (or partially erased state). A discontinuous filament 405 is shown having an electrical discontinuity between discontinuous filament 405 (at a bottom portion thereof) and bottom electrode 306. This results in response to an erase pulse applying an erase voltage (*e.g*., about 2volts to about 3 volts; or any suitable value or range there between, such as 2.3, 2.4, 2.5 volts, *etc.*) to bottom electrode 306 (or a negative voltage to top electrode 302) of a two-terminal resistive switching device 305A containing an electrically continuous filament 320.

The inventors of the present disclosure have discovered that while discontinuous filament 405 can properly be measured at a low resistance state (*e.g.,* a cell current less than 1µA; see erase 626 and partial erase 628 at Figure 6, *infra*), discontinuous filament 405 can be vulnerable to reverting to a fully conductive, programmed state. This leads to a data failure (specifically: an erase failure or a reset failure), in which a cell that should be in a reset state (*e.g.,* a '0' binary value) reads instead as a program state (*e.g.,* a '1' binary value). This can occur, for example, where one or more ions near a bottom edge of discontinuous filament 405 drifts into the switching layer 304 between the bottom edge and bottom electrode 306, resulting in a tunneling current there between and a lower resistance state for two-terminal resistive switching device 305A. Drift or diffusion of ions within switching layer 304 is not uncommon, and thus the reversion to the lower resistance state is a realistic possibility. As a result, discontinuous filament 405 can measure as a properly erased (high resistance) state at a time of completion of an erase process, but may have an increased likelihood of reverting to a low resistance state.

To mitigate or avoid this process of memory failure, aspects of the present disclosure provide a weakly set filament 410 and an erase and weak program loop 415 for generating weakly set filament 410 as by two-terminal resistive switching device 305B at the bottom of Figure 4. Erase and weak program loop 415 can cycle between one or more erase pulses and one or more weak program pulses. The erase pulses apply a positive voltage to bottom electrode 306 to cause ions within switching layer 304 toward top electrode 302. The weak program pulses cause ions to drift toward bottom electrode 306, but supplies a relatively small current that drives few ions back toward bottom electrode 306. Repeated application of the erase pulse and weak program pulse tends to form a very thin, structurally weak filament as shown by continuous filament 420. In some instances, continuous filament 420 can have a width of only a few ions (*e.g.,* 1 - 5) in some portions thereof.

The thin and structurally weak filament has multiple characteristics suitable for an erase process. First, continuous filament 420 can have a cell current that is reliably and measurably smaller than a cell current of a thick and robust program filament, such as electrically continuous filament 320. See, for example, Figure 6, *infra,* comparing program current 622 with partial program current 624. As a result, continuous filament 420 can provide a cell current measurably lower than the program current and can therefore be defined as an erase state. Second, because continuous filament 420 can be only a few ions wide, diffusion or drift of ions over time within switching layer 304 tend to cause discontinuities in continuous filament 420, rather than restore a continuity in a discontinuous filament 405. As a result, a weakly set continuous filament 420 can mitigate or avoid erase failures, significantly enhancing longevity of a high resistance state of a two-terminal memory cell.

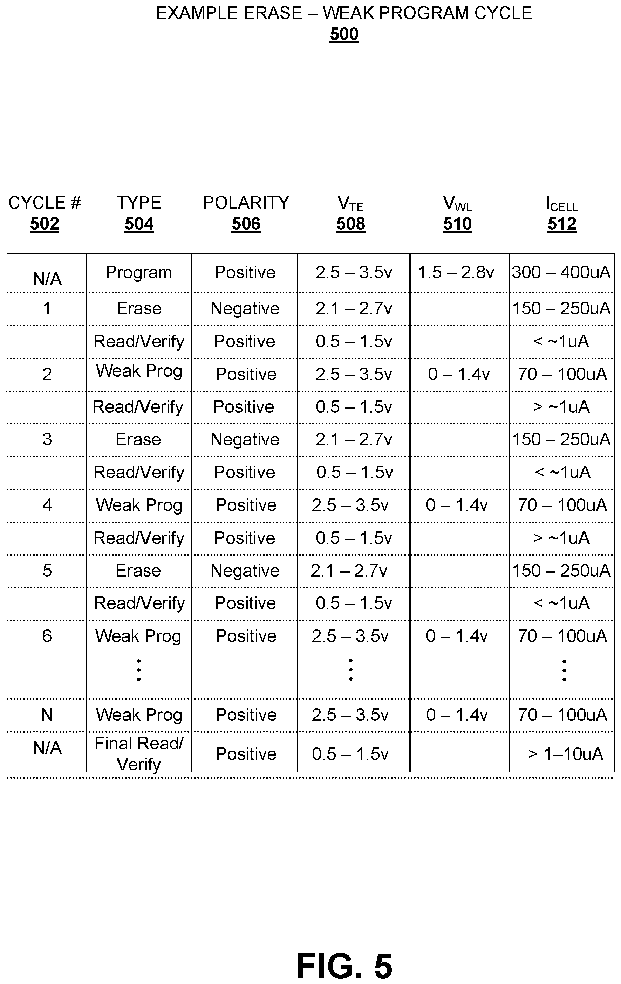

Figure 5 illustrates an example erase - weak program cycle 500 for generating a weak set filament having a relatively high electrical resistance defined as an erase state for a two-terminal resistive switching device, according to additional embodiments of the present disclosure. Different portions of cycle 500 are shown in the table, with cycle number 502 at a left column, followed by cycle type 504, signal polarity 506, top electrode voltage V_{TE} 508 at a top electrode of the two-terminal resistive switching device, wordline voltage V_{WL} 510 at a gate node of a transistor device, and current through the cell I_{CELL} 512.

A first cycle is a program process that precedes erase - weak program cycle 500, and has a positive signal with V_{TE} 508 of 2.5 - 3.5 volts, a V_{WL} 510 of 1.5 - 2.8 volts and an I_{CELL} 512 of about 300µA to about 400µA.

Beginning with the erase - weak program cycle 500, a first cycle is an erase cycle that applies a negative signal polarity of about (-)2.1 to (-)2.7 volts at a top electrode of the cell. Although not shown, V_{WL} 510 for the erase pulse can be about 1.5 to 2.5 volts. A read-verify pulse of about 0.5 to 1.5 volts at V_{TE} 508 can be compared with a 1µA threshold, and in at least some embodiments erase process cycle number 1 can be repeated until read-verify measures a cell current < 1µA.

Following the erase process and read-verify, a second cycle (cycle # 2) can be implemented. The second cycle can be a weak program with positive V_{TE} 508 of 2.5 to 3.5 volts. A wordline voltage V_{WL} 510 can be between about 0 and 1.4volts and I_{CELL} 512 of between 70µA and 100µA. A subsequent read-verify can be implemented to determine whether I_{CELL} > 1µA (and less than about 10µA), and weak program cycle number 2 can be repeated until I_{CELL} 512 is above the 1µA level.

As shown, erase cycles and weak program cycles can continue, with read-verify cycles interspersed there between until the process finishes. In some embodiments, the process can finish after a predetermined cycle number 502 or until read-verify shows I_{CELL} 512 satisfying a condition, or within a predetermined range (*e.g.,* >1µA; between 2µA - 10µA, *etc.*) one or more times.

Figure 6 depicts an example graph of read current 602 for several two-terminal memory cells (identified as cycle counts 604) according to aspects of the present disclosure. Read current values for program cells 622 are shown to have magnitudes above about 40µA. A program signal limit 614 is set at 40µA and can generally distinguish the program cells 622; however, program signal 614 limit could also be reduced to 30µA or 20µA or a suitable value there between to provide more sensing margin for the program cells 622.

Weakly erased or partial program cells 624 are shown with cell currents typically above the erase limit 612 of about 1µA and generally below 10µA. When program signal 614 is above 20µA, *e.g.,* partial program cells 624 can readily be distinguished from program cells 622. Where partial program cells 624 are embodied by a thin, weakly formed continuous filament such as shown at Figure 4, *supra* with continuous filament 420, diffusion and drift of ions over time tends to form discontinuities in continuous filament 420, causing reduced cell current rather than reversion to program cells 622. Accordingly, such a continuous filament 420 can reliably be maintained below the program limit 614 avoiding memory loss for the erase state.

Below erase limit 612 erase state cells 626 and partial erase state cells 628 are shown. These measure reliably below erase limit 612. However, as described above at Figure 4, a discontinuous filament 405 can measure to a read current 602 that should be a partial erase state cell 628 or even an erase state cell 626. Yet this can be deceptive, as a mechanism for restoring full continuity to program cells 622 can occur where a few ions drift back into place between bottom electrode 206 and a bottom edge of discontinuous filament 405 as described above. Accordingly, even though partial erase state cells 628 measure far below erase limit 612, a mechanism exists for some of these to revert to program cells 622, resulting in memory loss. In contrast, while partial program cells 624 have higher read current 602 than partial erase state cells 628, viable mechanisms for partial program cells 624 to revert to program cells 622 are not likely, and far more likely is formation of a discontinuity that produces a read current 602 of erase state cells 626. Accordingly, though initially measuring at higher read current 602, diffusion and drift of ions over time cause increase in resistance of partial program cells 624 and avoidance of memory failure, whereas similar diffusion or drift of ions over time for partial erase state cells 628 cause sharp reduction in resistance of partial erase state cells 628, leading to memory failure. Based on the foregoing, and based on the sufficient sensing margin between partial program cells 624 and program cells 622, aspects of the present disclosure weakly set filaments such as shown at continuous filament 420 and define the weakly set filaments as an erase state to more reliably avoid memory loss for the erase state in two-terminal memory cells according to the present disclosure.

The diagrams included herein are described with respect to several resistive switching devices, arrays of resistive switching devices, array circuitry and or an integrated circuit device(s) comprising multiple circuits or arrays. It should be appreciated that such diagrams can include those switching devices, circuitry, and circuit devices, specified therein, some of the specified switch devices / circuitry / circuit devices, or additional switching devices / circuitry / circuit devices not explicitly depicted but known in the art or reasonably conveyed to those of skill in the art by way of the context provided herein. Components of disclosed integrated circuit devices can also be implemented as sub-components of another disclosed component, whereas other components disclosed as sub-components can be separate components in various embodiments. For example, operation circuitry 150 can include program circuitry 152 whereas erase circuit(s) 154 or read circuit(s) 156 can be implemented utilizing separate operation circuitry 150. Further, embodiments within a particular Figure of the present specification can be applied in part or in whole to other embodiments depicted in other Figures without limitation, subject only to suitability to achieving a disclosed function or purpose as understood by one of skill in the art, and *vice versa.* As an example, any of two-terminal resistive switching devices: 305, 305A, 305B can be substituted for two-terminal switching device 210.

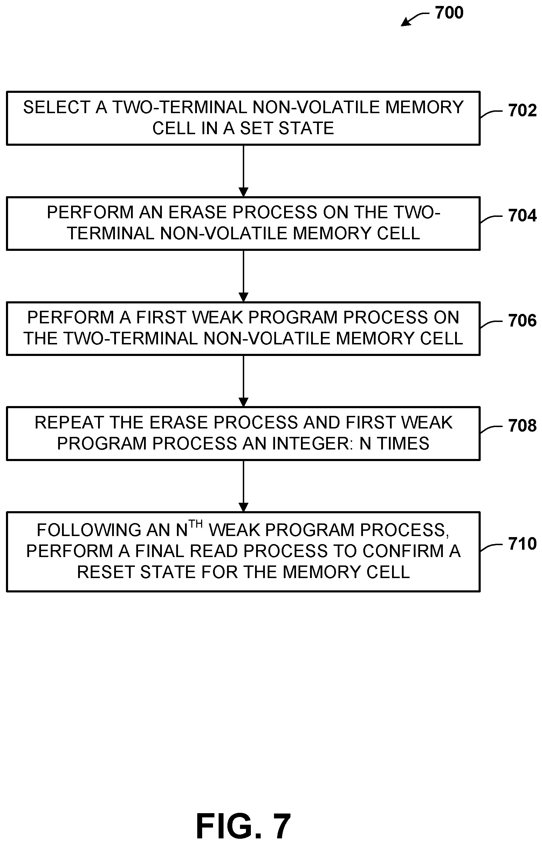

In view of the exemplary diagrams described *supra,* process methods that can be implemented in accordance with the disclosed subject matter will be better appreciated with reference to the flow charts of Figures 7 - 8. While for purposes of simplicity of explanation, the methods of Figures 7 - 8 are shown and described as a series of blocks, it is to be understood and appreciated that the claimed subject matter is not limited by the order of the blocks, as some blocks may occur in different orders or concurrently with other blocks from what is depicted and described herein. Moreover, not all illustrated blocks may be required to implement the methods described herein, and in some embodiments additional steps known in the art or reasonably conveyed to one of ordinary skill in the art by way of the context provided herein can be implemented as part of a disclosed method within the scope of the present disclosure. Moreover, some steps illustrated as part of one process can be implemented for another process where suitable; other steps of one or more processes can be added or substituted in other processes disclosed herein within the scope of the present disclosure. Additionally, it should be further appreciated that the methods disclosed throughout this specification are capable of being stored on an article of manufacture to facilitate transporting and transferring such methods to an electronic device, stored in embedded memory within the electronic device, and so forth. The term article of manufacture, as used, is intended to encompass a computer program accessible from any computer-readable device, device in conjunction with a carrier, or storage medium, or the like.

Figure 7 depicts a flowchart of a sample method 700 for erasing a two-terminal memory cell according to alternative or additional embodiments of the present disclosure. At 702, method 700 can comprise selecting a two-terminal non-volatile memory cell in a set memory cell state. At 704, method 700 can comprise performing an erase process on the two-terminal non-volatile memory cell, and at 706 method 700 can comprise performing a weak program process on the two-terminal non-volatile memory cell. Additionally, at 708, method 700 can comprise repeating the erase process and the weak program process an integer: N times. In some embodiments, N is a positive integer larger than zero. In other embodiments, N is a positive integer larger than one (*e.g.,* 2, 3, 4, 5, 6... 10, *... etc.*)*.* At 710, method 700 can comprise terminating the erasing, following an N^{th} erase process and N^{th} weak program process. In some embodiments, a final read-verify process can be performed prior to terminating the erasing. The read-verify can be utilized to confirm a reset state is achieved for the memory cell, as a condition to terminating the erasing. Achieving the reset state can be a read current magnitude greater than a minimum current magnitude, or within a range of current magnitudes. The minimum current magnitude can be 1µA or about 1µA, 2µA or about 2µA, 3µA or about 3µA or the like. A suitable range of current magnitudes can be about 1µA to about 10µA; about 2µA to about 10µA; about 2µA to about 15 or 20µA, or other suitable range of values.

In some embodiments, method 700 can further comprise, in response to repeating the erase process and the weak program process the integer: N times, performing a read process on the two-terminal non-volatile memory cell. Additionally, method 700 can comprise confirming a current of the two-terminal non-volatile memory cell is above a first current magnitude defining a reset memory cell state and below a second current magnitude defining the set memory cell state. In another embodiment, method 700 can comprise confirming the current of the two-terminal non-volatile memory cell is below a third current magnitude defining a weakly set memory cell state and above the first current magnitude, wherein the third current magnitude is smaller than the second current magnitude. In some embodiments, current values can be selected for a composition of two-terminal resistive switching device. For instance, for a switching device having an AlO switching layer and an aluminum, a copper or a silver containing top electrode layer, the first current magnitude can be about 1µA, the second current magnitude can be within a range from about 30µA to about 50µA, and the third current magnitude can be about 10µA.

In further embodiments of the present disclosure, the erase process can apply a voltage across the two-terminal non-volatile memory cell of about 2.4 volts (V) and a maximum current of about 200µA. In yet another embodiment, a program process for programming the two-terminal non-volatile memory cell to the set memory cell state has a voltage from about 2.5 to about 3.5 volts and current from about 300µA to about 400µA, and the weak program process has a second voltage from about 2.5 to about 3.5 volts, and a second current of 100µA or less.

In at least some embodiments, the two-terminal non-volatile memory cell is connected in serial to a transistor that comprises a gate node and a channel, one terminal of the two-terminal non-volatile memory cell is connected to the channel node, and a gate voltage applied to the gate node of the transistor controls current to the two-terminal non-volatile memory cell in response to the program process and the weak program process. In such embodiments, the gate voltage can be 1.5v to 2.8v for the program process to provide the current from about 300µA to about 400µA, and the method further comprises setting the gate voltage to about 0v to about 1v for the weak program process to provide the second current of 100µA or less. In one or more embodiments, the two-terminal non-volatile memory cell is a filamentary resistive switching memory cell.

In further embodiments, N can be a variable integer greater than one. Further, method 700 can comprise reading a current value of the two-terminal non-volatile memory cell following the weak program process, and comparing the current value to a range of current values associated with a weakly set memory cell state. Moreover, method 700 can comprise one of: terminating the erasing in response to the current value falling within the range of current values associated with the weakly set memory cell state; or incrementing the value of N and repeating the erase process and the weak program process an N+1^{th} time. In some such embodiments, the weak program process applies a low program current to the two-terminal non-volatile memory cell that is about 1/3 to about ¼ a program current associated with a program process for changing the two-terminal non-volatile memory cell from a reset memory cell state to the set memory cell state. In addition, the range of current values associated with the weakly set memory cell state is greater than 1µA and less than or equal to 10µA.

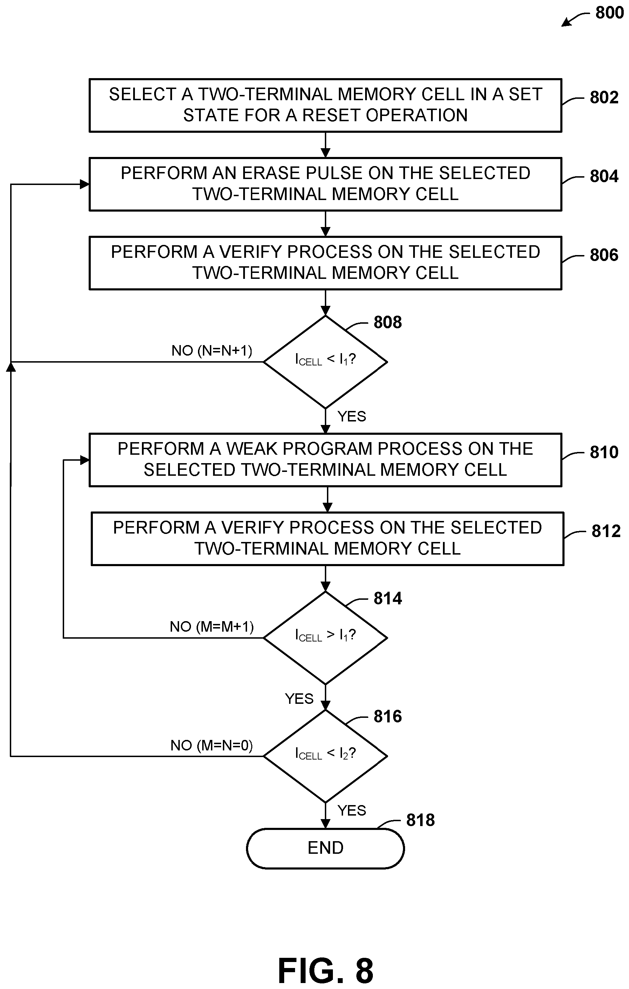

Referring to Figure 8, there is disclosed a method 800 for erasing a two-terminal memory cell according to alternative or additional embodiments of the present disclosure. At 802, method 800 can comprise selecting a two-terminal non-volatile memory cell in a set memory cell state, and at 804 method 800 can comprise performing an erase process on the two-terminal non-volatile memory cell. At 806 method 800 can additionally comprise performing a verify process on the selected two-terminal memory cell. At 808, a determination can be made as to whether a cell current I_{CELL} of the selected two-terminal memory cell in response to the verify process is less than a first current threshold associated with a reset state: I₁. If I_{CELL} is less than I₁ method 800 can proceed to reference number 810; otherwise, method 800 increments an integer N by N = N +1 and returns to reference number 804. N can be an integer associated with a number of erase pulses implemented by method 800 at reference number 804.

At 810, method 800 can comprise performing a weak program process on the selected two-terminal memory cell, and at 812 method 800 can comprise performing a verify process on the selected two-terminal memory cell. In response to the verify process, method 800 can determine, at reference number 814, whether I_{CELL} of the selected two-terminal memory cell is greater than the first current threshold: I₁. If not, method 800 can increment a second integer M by M = M + 1 and can return to reference number 810. Second integer M can be an integer associated with a number of weak program pulses implemented by method 800 at reference number 810.

If I_{CELL} is greater than I₁ method 800 can proceed to reference number 816. At 816, method 800 can comprise determining whether I_{CELL} is less than a second current threshold: I₂. If I_{CELL} is less than the second current threshold method 800 proceeds to 818 and ends. If I_{CELL} is not less than the second current threshold, method 800 can reset both N and M to 0 and return to reference number 804. In some disclosed embodiments, I₁ can be about 1, 2 or 3µA, whereas I₂ can be about 8-10, 10-12 or 15-20µA, or any suitable value or range there between.

In an embodiment, the second current threshold can be associated with a set state. In such embodiment(s), terminating the reset operation can further comprise determining the read current value is lower than a third current threshold associated with a weak set state, wherein the third current threshold can be from about 20 to about 35 percent of the second current threshold.

In another embodiment, method 800 can further comprise determining the current value is not greater than the first current threshold at reference number 814 and can further comprise performing a second weak program process on the selected two-terminal memory cell. Method 800 can then comprise reading a second current value of the selected two-terminal memory cell and comparing the second current value to the first current threshold and to the second current threshold. In response to the comparison, method 800 can comprise one of: performing a third weak program process on the selected two-terminal memory cell in response to the second current value being lower than the first current threshold; performing a second erase pulse on the selected two-terminal memory cell in response to the second current value being lower than the first current threshold; or proceeding with terminating the reset operation in response to the second current value being greater than the first current threshold and lower than the second current threshold.

In an alternative embodiment, method 800 can comprise determining the current value is not less than the second current threshold at reference number 816. Method 800 can then comprise performing a second erase pulse on the selected two-terminal memory cell, and performing a second weak program pulse on the selected two-terminal memory cell. Additionally, method 800 can comprise reading a second current value of the selected two-terminal memory cell and comparing the second current value to the first current threshold and to the second current threshold. Moreover, method 800 can comprise one of: performing a third weak program process on the selected two-terminal memory cell in response to the second current value being lower than the first current threshold; performing a third erase pulse on the selected two-terminal memory cell in response to the second current value being greater than the second current threshold; or proceeding with terminating the reset operation in response to the second current value being greater than the first current threshold and lower than the second current threshold.

In a further embodiment, determining whether the current value is greater than the first current threshold and lower than the second current threshold can further comprise determining whether the current value is greater than about 1µA and less than about 40µA. In an example, the method can further comprise determining whether the current value is lower than about 10µA associated with a weakly set state and conditioning the terminating the reset operation on the current value being lower than about 10µA.

In an embodiment(s), performing the weak program process can further comprise applying a voltage from about 2.5 to about 3.5 volts across the two-terminal memory cell and applying a weak program current of between 60µA and 100µA to the two-terminal memory cell. In at least one embodiment, applying the weak program current can further comprise applying a current compliance limit of about 100µA in conjunction with the weak program process. In an alternative or additional embodiment, the selected two-terminal memory cell comprises a first terminal coupled to a channel node of a select transistor, and applying the weak program current of between 60 µA and 100 µA to the two-terminal memory cell can further comprise applying a gate voltage in a range from about 0 to about 1.0 volts to a gate node of the select transistor in conjunction with applying the voltage from about 2.5 to about 3.5 volts across the two-terminal memory cell. In various embodiments, the two-terminal memory cell can be a filamentary resistive switching memory cell.

### EXAMPLE OPERATING ENVIRONMENTS

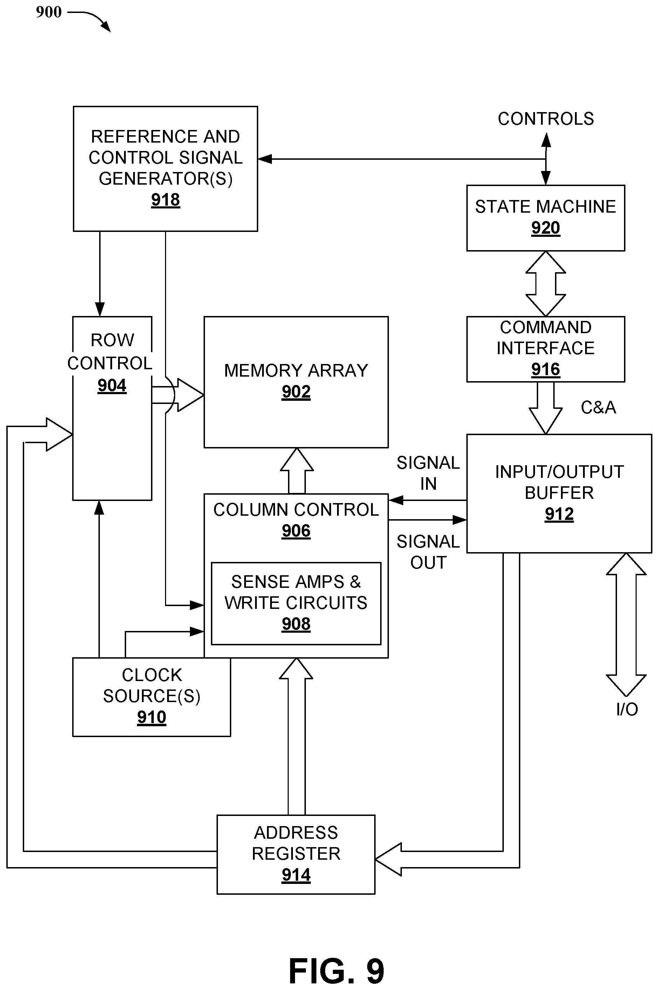

Figure 9 illustrates a block diagram of an example operating and control environment 900 for a memory array 902 of a memory device according to aspects of the subject disclosure. Control environment 900 and memory array 902 can be formed within a single semiconductor die in some embodiments, although the subject disclosure is not so limited and in other embodiments some components of control environment 900 can be formed on a separate semiconductor die communicatively linked to the single semiconductor die. In at least one aspect of the subject disclosure, memory array 902 can comprise memory selected from a variety of memory cell technologies. In at least one embodiment, memory array 902 can comprise a two-terminal memory technology, arranged in a compact two or three-dimensional architecture. Suitable two-terminal memory technologies can include resistive-switching memory, conductive-bridging memory, phase-change memory, organic memory, magneto-resistive memory, or the like, or a suitable combination of the foregoing. In a further embodiment, the two-terminal memory technology can be a two-terminal resistive switching technology.

A column controller 906 including sense amps and write circuits 908 can be formed adjacent to memory array 902. Moreover, column controller 906 can be configured to activate (or identify for activation) a subset of bit lines of memory array 902. Column controller 906 can utilize a control signal(s) provided by a reference and control signal generator(s) 918 to activate, as well as operate upon, respective ones of the subset of bitlines, applying suitable program, erase or read voltages to those bitlines. Non-activated bitlines can be kept at an inhibit voltage (also applied by reference and control signal generator(s) 918), to mitigate or avoid bit-disturb effects on these non-activated bitlines.

In addition, operating and control environment 900 can comprise a row controller 904. Row controller 904 can be formed adjacent to and electrically connected with word lines of memory array 902. Also utilizing control signals of reference and control signal generator(s) 918, row controller 904 can select one or more rows of memory cells with a suitable selection voltage. Moreover, row controller 904 can facilitate program, erase or read operations by applying suitable voltages at selected word lines.

Sense amps and write circuits 908 can read data from and write data to (respectively), the activated memory cells of memory array 902, which are selected by column control 906 and row control 904. Data read out from memory array 902 can be provided to an input/output buffer 912. Likewise, data to be written to memory array 902 can be received from the input/output buffer 912 and written to the activated memory cells of memory array 902.

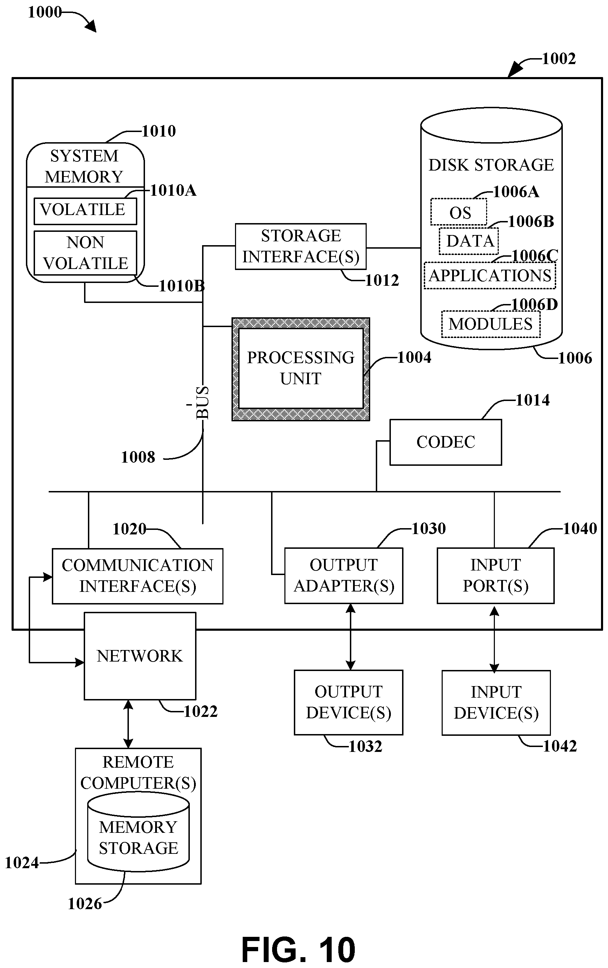

A clock source(s) 910 can provide respective clock pulses to facilitate timing for read, write, and program operations of row controller 904 and column controller 906. Clock source(s) 910 can further facilitate selection of word lines or bit lines in response to external or internal commands received by operating and control environment 900. Input/output buffer 912 can comprise a command and address input, as well as a bidirectional data input and output. Instructions are provided over the command and address input, and the data to be written to memory array 902 as well as data read from memory array 902 is conveyed on the bidirectional data input and output, facilitating connection to an external host apparatus, such as a computer or other processing device (not depicted, but see *e.g.,* computer 1002 of Figure 10, *infra*)*.*

Input/output buffer 912 can be configured to receive write data, receive an erase instruction, receive a status or maintenance instruction, output readout data, output status information, and receive address data and command data, as well as address data for respective instructions. Address data can be transferred to row controller 904 and column controller 906 by an address register 914. In addition, input data is transmitted to memory array 902 *via* signal input lines between column control 906 and input/output buffer 912, and output data is received from memory array 902 *via* sense amps (908) and provided on signal output lines to input/output buffer 912. Input data can be received from the host apparatus, and output data can be delivered to the host apparatus *via* the I/O bus.

Commands received from the host apparatus can be provided to a command interface 916. Command interface 916 can be configured to receive external control signals from the host apparatus and determine whether data input to the input/output buffer 912 is write data, a command, or an address. Input commands can be transferred to a state machine 920.

State machine 920 can be configured to manage programming and reprogramming of memory array 902. Instructions provided to state machine 920 are implemented according to control logic configurations, enabling state machine 920 to manage read, write, erase, data input, data output, and other functionality associated with memory cell array 902. In some aspects, state machine 920 can send and receive acknowledgments and negative acknowledgments regarding successful receipt or execution of various commands. In further embodiments, state machine 920 can decode and implement status-related commands, decode and implement configuration commands, and so on.

To implement read, write, erase, input, output, *etc.,* functionality, state machine 920 can control clock source(s) 910 or reference and control signal generator(s) 918. Control of clock source(s) 910 can cause output pulses configured to facilitate row controller 904 and column controller 906 implementing the particular functionality. Output pulses can be transferred to selected bit lines by column controller 906, for instance, or word lines by row controller 904, for instance.

In connection with Figure 10, the systems, devices, or processes described herein can be embodied within hardware, such as a single integrated circuit (IC) chip, multiple ICs, an application specific integrated circuit (ASIC), or the like. Further, the order in which some or all of the process blocks appear in each process should not be deemed limiting. Rather, it should be understood that some of the process blocks can be executed in a variety of orders, not all of which may be explicitly illustrated herein.

With reference to Figure 10, a suitable environment 1000 for implementing various aspects of the claimed subject matter includes a computer 1002. The computer 1002 includes a processing unit 1004, a system memory 1010, a codec 1014, and a system bus 1008. The system bus 1008 couples system components including, but not limited to, the system memory 1010 to the processing unit 1004. The processing unit 1004 can be any of various available processors. Dual microprocessors and other multiprocessor architectures also can be employed as the processing unit 1004.

The system bus 1008 can be any of several types of bus structure(s) including the memory bus or memory controller, a peripheral bus or external bus, or a local bus using any variety of available bus architectures including, but not limited to, Industrial Standard Architecture (ISA), Micro-Channel Architecture (MSA), Extended ISA (EISA), Intelligent Drive Electronics (IDE), VESA Local Bus (VLB), Peripheral Component Interconnect (PCI), Card Bus, Universal Serial Bus (USB), Advanced Graphics Port (AGP), Personal Computer Memory Card International Association bus (PCMCIA), Firewire (IEEE 1394), and Small Computer Systems Interface (SCSI), Compute eXpress Link (CXL), high speed Serial Peripheral Interface (SPI) interfaces (*e.g*., HyperFlash, and so forth), Inter-Integrated Circuit (I²C) communication protocol, I³C protocol, *etc.*

The system memory 1010 includes volatile memory 1010A and non-volatile memory 1010B. The basic input/output system (BIOS), containing the basic routines to transfer information between elements within the computer 1002, such as during start-up, is stored in non-volatile memory 1010B. In addition, according to present innovations, codec 1014 may include at least one of an encoder or decoder, wherein the at least one of an encoder or decoder may consist of hardware, software, or a combination of hardware and software. Although, codec 1014 is depicted as a separate component, codec 1014 may be contained within non-volatile memory 1010B. By way of illustration, and not limitation, non-volatile memory 1010B can include read only memory (ROM), programmable ROM (PROM), electrically programmable ROM (EPROM), electrically erasable programmable ROM (EEPROM), or flash memory, two-terminal memory, and so on. Volatile memory 1010A includes random access memory (RAM), and in some embodiments can embody a cache memory. By way of illustration and not limitation, RAM is available in many forms such as static RAM (SRAM), dynamic RAM (DRAM), synchronous DRAM (SDRAM), double data rate SDRAM (DDR SDRAM), and enhanced SDRAM (ESDRAM) among others.

Computer 1002 may also include removable/non-removable, volatile/non-volatile computer storage medium. Figure 10 illustrates, for example, disk storage 1006. Disk storage 1006 includes, but is not limited to, devices like a magnetic disk drive, solid state disk (SSD) floppy disk drive, tape drive, Jaz drive, Zip drive, LS-100 drive, flash memory card, or memory stick, universal serial bus (USB) memory, mini-USB memory, micro-USB memory and other modalities of non-volatile memory hardware. In addition, disk storage 1006 can include storage medium separately or in combination with other storage medium including, but not limited to, an optical disk drive such as a compact disk ROM device (CD-ROM), CD recordable drive (CD-R Drive), CD rewritable drive (CD-RW Drive) or a digital versatile disk ROM drive (DVD-ROM). To facilitate connection of the disk storage devices 1006 to the system bus 1008, a removable or non-removable interface is typically used, such as storage interface 1012. It is appreciated that storage devices 1006 can store information related to a user. Such information might be stored at or provided to a server or to an application running on a user device. In one embodiment, the user can be notified (*e.g.,* by way of output device(s) 1032) of the types of information that are stored to disk storage 1006 or transmitted to the server or application. The user can be provided the opportunity to opt-in or opt-out of having such information collected and/or shared with the server or application (*e.g*., by way of input from input device(s) 1042).

It is to be appreciated that Figure 10 describes software that acts as an intermediary between users and the basic computer resources described in the suitable operating environment 1000. Such software includes an operating system 1006A. Operating system 1006A, which can be stored on disk storage 1006, acts to control and allocate resources of the computer system 1002. Applications 1006C take advantage of the management of resources by operating system 1006A through program modules 1006D, and program data 1006D, such as the boot/shutdown transaction table and the like, stored either in system memory 1010 or on disk storage 1006. It is to be appreciated that the claimed subject matter can be implemented with various operating systems or combinations of operating systems.

A user enters commands or information into the computer 1002 through input device(s) 1042. Input devices 1042 include, but are not limited to, a pointing device such as a mouse, trackball, stylus, touch pad, keyboard, microphone, joystick, game pad, satellite dish, scanner, TV tuner card, digital camera, digital video camera, web camera, and the like. These and other input devices connect to the processing unit 1004 through the system bus 1008 *via* input port(s) 1040. Input port(s) 1040 include, for example, a serial port, a parallel port, a game port, and a universal serial bus (USB). Output device(s) 1032 use some of the same type of ports as input device(s) 1042. Thus, for example, a USB port may be used to provide input to computer 1002 and to output information from computer 1002 to an output device 1032. Output adapter 1030 is provided to illustrate that there are some output devices 1032 like monitors, speakers, and printers, among other output devices 1032, which require special adapters. The output adapters 1030 include, by way of illustration and not limitation, video and sound cards that provide a means of connection between the output device 1032 and the system bus 1008. It should be noted that other devices and/or systems of devices provide both input and output capabilities such as remote computer(s) 1038.

Computer 1002 can operate in a networked environment using logical connections to one or more remote computers, such as remote computer(s) 1024. The remote computer(s) 1024 can be a personal computer, a server, a router, a network PC, a workstation, a microprocessor based appliance, a peer device, a smart phone, a tablet, or other network node, and typically includes many of the elements described relative to computer 1002. For purposes of brevity, only a memory storage device 1026 is illustrated with remote computer(s) 1024. Remote computer(s) 1024 is logically connected to computer 1002 through a network 1022 and then connected *via* communication interface(s) 1020. Network 1022 encompasses wire or wireless communication networks such as local-area networks (LAN) and wide-area networks (WAN) and cellular networks. LAN technologies include Fiber Distributed Data Interface (FDDI), Copper Distributed Data Interface (CDDI), Ethernet, Token Ring and the like. WAN technologies include, but are not limited to, point-to-point links, circuit switching networks like Integrated Services Digital Networks (ISDN) and variations thereon, packet switching networks, and Digital Subscriber Lines (DSL).

Communication interface(s) 1020 refers to the hardware/software employed to connect the network 1022 to the bus 1008. While communication interface(s) 1020 is shown for illustrative clarity inside computer 1002, it can also be external to computer 1002. The hardware/software necessary for connection to the network 1022 includes, for exemplary purposes only, internal and external technologies such as, modems including regular telephone grade modems, cable modems and DSL modems, ISDN adapters, and wired and wireless Ethernet cards, hubs, and routers.

The illustrated aspects of the disclosure may also be practiced in distributed computing environments where certain tasks are performed by remote processing devices that are linked through a communications network. In a distributed computing environment, program modules or stored information, instructions, or the like can be located in local or remote memory storage devices.

Moreover, it is to be appreciated that various components described herein can include electrical circuit(s) that can include components and circuitry elements of suitable value in order to implement the embodiments of the subject disclosure. Furthermore, it can be appreciated that many of the various components can be implemented on one or more IC chips. For example, in one embodiment, a set of components can be implemented in a single IC chip. In other embodiments, one or more of respective components are fabricated or implemented on separate IC chips.

In regard to the various functions performed by the above described components, architectures, circuits, processes and the like, the terms (including a reference to a "means") used to describe such components are intended to correspond, unless otherwise indicated, to any component which performs the specified function of the described component (*e.g*., a functional equivalent), even though not structurally equivalent to the disclosed structure, which performs the function in the herein illustrated exemplary aspects of the embodiments. In this regard, it will also be recognized that the embodiments include a system as well as a computer-readable medium having computer-executable instructions for performing the acts and/or events of the various processes.

In addition, while a particular feature may have been disclosed with respect to only one of several implementations, such feature may be combined with one or more other features of the other implementations as may be desired and advantageous for any given or particular application. Furthermore, to the extent that the terms "includes," and "including" and variants thereof are used in either the detailed description or the claims, these terms are intended to be inclusive in a manner similar to the term "comprising".

As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

In other embodiments, combinations or sub-combinations of the above disclosed embodiments can be advantageously made. The block diagrams of the architecture and flow charts are grouped for ease of understanding. However, it should be understood that combinations of blocks, additions of new blocks, re-arrangement of blocks, and the like are contemplated in alternative embodiments of the present disclosure.
It is also understood that the examples and embodiments described herein are for illustrative purposes only and that various modifications or changes in light thereof will be suggested to persons skilled in the art and are to be included within the spirit and purview of this application and scope of the appended claims.

## Claims

1. A method for erasing a two-terminal memory cell, comprising:
select a two-terminal non-volatile memory cell in a set memory cell state;
perform an erase process on the two-terminal non-volatile memory cell;
perform a weak program process on the two-terminal non-volatile memory cell;
repeat the erase process and the weak program process an integer: N times, wherein N is larger than one; and
following an N^{th} erase process and N^{th} weak program process, terminate the method.

2. The method of claim 1, further comprising, in response to repeating the erase process and the weak program process the integer: N times, perform a read process on the two-terminal non-volatile memory cell, and confirm a current of the two-terminal non-volatile memory cell is above a first current magnitude defining a reset memory cell state and below a second current magnitude defining the set memory cell state.

3. The method of claim 2, further comprising confirming the current of the two-terminal non-volatile memory cell is below a third current magnitude defining a weakly set memory cell state and above the first current magnitude, wherein the third current magnitude is smaller than the second current magnitude.

4. The method of claim 3, wherein the first current magnitude is about 1 microamp (µA), the second current magnitude is within a range from about 30 to about 50µA and the third current magnitude is about 10µA.

5. The method of claim 1, wherein the erase process applies a voltage across the two-terminal non-volatile memory cell of about 2.4 volts (V) and a maximum current of about 200 µA.

6. The method of claim 1, wherein a program process for programming the two-terminal non-volatile memory cell to the set memory cell state has a voltage from about 2.5 to about 3.5 volts and a current from about 300 to about 400 µA, and wherein the weak program process has a second voltage from about 2.5 to about 3.5 volts, and a second current of 100 µA or less.

7. The method of claim 6, wherein:
the two-terminal non-volatile memory cell is connected in serial to a transistor that comprises a gate node and a channel node;
one terminal of the two-terminal non-volatile memory cell is connected to the channel node;
a gate voltage applied to the gate node of the transistor controls current to the two-terminal non-volatile memory cell in response to the program process and the weak program process;
the gate voltage is 1.5V to 2.8V for the program process to provide the current from about 300 to about 400 µA; and the method further comprises setting the gate voltage to about 0V to about 1V for the weak program process to provide the second current of 100 µA or less.

8. The method of claim 1, wherein the two-terminal non-volatile memory cell is a filamentary resistive switching memory cell.

9. The method of claim 1, wherein N is a variable integer greater than one, and the method further comprises:
reading a current value of the two-terminal non-volatile memory cell following the weak program process;
comparing the current value to a range of current values associated with a weakly set memory cell state; and one of:
terminating the erasing in response to the current value being within the range of current values associated with the weakly set memory cell state; or
incrementing a value of N and repeating the erase process and the weak program process an N+1^{th} time.

10. The method of claim 9, wherein:
the weak program process applies a low program current to the two-terminal non-volatile memory cell that is about 1/3 to about ¼ a program current associated with a program process for changing the two-terminal non-volatile memory cell from a reset memory cell state to the set memory cell state; and
the range of current values associated with the weakly set memory cell state is greater than 1 µA and less than or equal to 10 µA.

11. A method for erasing a two-terminal memory cell, comprising:
selecting a two-terminal memory cell in a set state for a reset operation;
performing an erase pulse on the selected two-terminal memory cell;
performing a weak program process on the selected two-terminal memory cell;
read a current value of the selected two-terminal memory cell;
determine whether the current value is greater than a first current threshold associated with a reset state and lower than a second current threshold associated with the set state; and
terminate the reset operation in response to determining a read current value of the selected two-terminal memory cell is greater than the first current threshold and lower than the second current threshold.

12. The method of claim 11, wherein terminating the reset operation further comprises determining the read current value is lower than a third current threshold associated with a weak set state, wherein the third current threshold is from about 20 to about 35 percent of the second current threshold.

13. The method of claim 11, further comprising:
determining the current value is not greater than the first current threshold;
perform a second weak program process on the selected two-terminal memory cell;
reading a second current value of the selected two-terminal memory cell and comparing the second current value to the first current threshold and to the second current threshold; and one of:
perform a third weak program process on the selected two-terminal memory cell in response to the second current value being lower than the first current threshold;
perform a second erase pulse on the selected two-terminal memory cell in response to the second current value being greater than the second current threshold; or
proceed with terminating the reset operation in response to the second current value being greater than the first current threshold and lower than the second current threshold.

14. The method of claim 11, further comprising:
determining the current value is not less than the second current threshold;
perform a second erase pulse on the selected two-terminal memory cell;
perform a second weak program pulse on the selected two-terminal memory cell;
reading a second current value of the selected two-terminal memory cell and comparing the second current value to the first current threshold and to the second current threshold; and one of:
perform a third weak program process on the selected two-terminal memory cell in response to the second current value being lower than the first current threshold;
perform a third erase pulse on the selected two-terminal memory cell in response to the second current value being greater than the second current threshold; or
proceed with terminating the reset operation in response to the second current value being greater than the first current threshold and lower than the second current threshold.

15. The method of claim 11, wherein determining whether the current value is greater than the first current threshold and lower than the second current threshold further comprises determining whether the current value is greater than about 1 µA and less than about 40 µA.

16. The method of claim 15, further comprising determining whether the current value is lower than about 10 µA associated with a weak set state and conditioning the terminating the reset operation on the current value being lower than about 10 µA.

17. The method of claim 11, wherein performing the weak program process further comprises:
applying a voltage from about 2.5 to about 3.5 volts across the two-terminal memory cell; and
applying a weak program current of between 60 µA and 100 µA to the two-terminal memory cell.

18. The method of claim 17, wherein applying the weak program current further comprises applying a current compliance limit of about 100 µA in conjunction with the weak program process.

19. The method of claim 17, wherein the selected two-terminal memory cell comprises a first terminal coupled to a channel node of a select transistor, and wherein applying the weak program current of between 60 µA and 100 µA to the two-terminal memory cell further comprises applying a gate voltage in a range from about 0 to about 1.0 volts to a gate node of the select transistor in conjunction with applying the voltage from about 2.5 to about 3.5 volts across the two-terminal memory cell.

20. The method of claim 11, wherein the selected two-terminal memory cell is a filamentary resistive switching memory cell.
